(19) Europäisches Patentamt / European Patent Office / Office européen des brevets

(11) **EP 3 023 386 B1**

(12) **FASCICULE DE BREVET EUROPEEN**

(45) Date de publication et mention de la délivrance du brevet:
**06.10.2021  Bulletin 2021/40**

(51) Int Cl.:
*B82Y 10/00* (2011.01)        *B82Y 40/00* (2011.01)
*H01L 29/66* (2006.01)        *H01L 29/06* (2006.01)
*H01L 29/10* (2006.01)        *H01L 29/16* (2006.01)
*H01L 29/41* (2006.01)

(21) Numéro de dépôt: **15195811.3**

(22) Date de dépôt: **23.11.2015**

(54) **PROCÉDÉ DE RÉALISATION D'UN RÉSEAU DE NANOSTRUCTURES COMPRENANT UNE ÉTAPE DE DÉSOXYDATION ET UNE ÉTAPE DE RENFORCEMENT DE LA LIAISON ENTRE LES NANOSTRUCTURES.**

HERSTELLUNGSVERFAHREN FÜR EIN NETZ AUS NANOSTRUKTUREN, WELCHES EINEN SCHRITT DER DESOXIDATION UND EINEN SCHRITT ZUR FESTIGUNG DER VERBINDUNG ZWISCHEN DEN NANOSTRUKTUREN BEINHALTET.

METHOD OF FABRICATING A NETWORK OF NANOSTRUCTURES COMPRISING A STEP OF DEOXIDATION AND A STEP OF REINFORCING THE CONNECTION BETWEEN THE NANOSTRUCTURES.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.11.2014  FR 1461326**

(43) Date de publication de la demande:
**25.05.2016  Bulletin 2016/21**

(73) Titulaires:
- **COMMISSARIAT À L'ÉNERGIE ATOMIQUE ET AUX ÉNERGIES ALTERNATIVES
  75015 Paris (FR)**
- **Institut Polytechnique de Grenoble
  38000 Grenoble (FR)**
- **Centre National de la Recherche Scientifique
  75016 Paris (FR)**

(72) Inventeurs:
- **SERRE, Pauline
  38360 SASSENAGE (FR)**

- **BARON, Thierry
  38120 SAINT-EGREVE (FR)**
- **TERNON, Céline
  38950 SAINT MARTIN LE VINOUX (FR)**

(74) Mandataire: **Decobert, Jean-Pascal
  Cabinet Hautier
  20, rue de la Liberté
  06000 Nice (FR)**

(56) Documents cités:
WO-A1-2010/040967        WO-A1-2014/070611
WO-A2-2007/100551        US-A1- 2011 001 117
US-A1- 2013 146 335      US-A1- 2014 042 390

- **PAULINE SERRE ET AL: "Percolating silicon nanowire networks with highly reproducible electrical properties", NANOTECHNOLOGY, IOP, BRISTOL, GB, vol. 26, no. 1, 8 décembre 2014 (2014-12-08), page 15201, XP020276375, ISSN: 0957-4484, DOI: 10.1088/0957-4484/26/1/015201 [extrait le 2014-12-08]**
- **None**

## Description

DOMAINE TECHNIQUE DE L'INVENTION

La présente invention concerne généralement les « nanonets » de l'anglais « nanostructured network » qui désigne un réseau de structures de taille nanométrique (nanomètre ou nm = $10^{-9}$ mètre), par exemple, un réseau de fils de taille nanométrique ou nanofils. L'invention décrit plus particulièrement un procédé de réalisation d'un tel réseau de nanostructures à partir d'un ou de matériaux semi-conducteurs sur un substrat.

ÉTAT DE LA TECHNIQUE

Les nanonets suscitent un grand intérêt en raison du spectre très large d'applications qu'ils sont susceptibles de couvrir incluant l'électronique, l'optique, la mécanique et la chimie et afin de pouvoir développer de nouveaux dispositifs, généralement de petites tailles et très performants. Ils sont applicables dans des domaines aussi divers que, par exemple, la production d'énergie à partir de lumière ou photovoltaïque, la détection d'espèces chimiques ou biologiques, la détection ou la production de lumière.

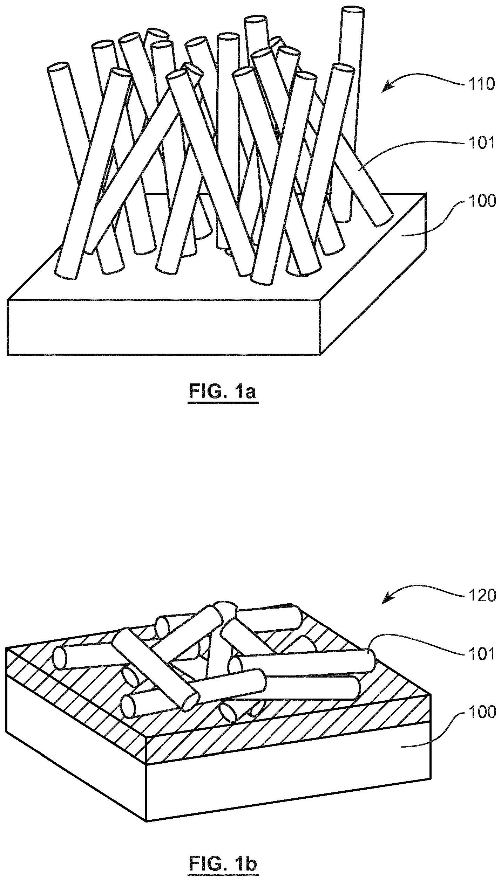

Les nanonets sont généralement classés selon deux catégories schématisées sur les figures 1a et 1b. En partant de structures de taille nanométrique ou nanostructures unidimensionnelles, encore dites «1D», présentant un fort facteur de forme, comme par exemple un nanofil 101, c'est-à-dire un fil de taille nanométrique ayant un rapport longueur sur diamètre très élevé, on sait fabriquer des réseaux de telles nanostructures disposées aléatoirement sur un substrat 100. Comme illustré sur la figure 1a, on qualifie alors de nanonet tridimensionnel ou « 3D » ceux 110 dont l'épaisseur (c'est-à-dire la dimension suivant l'épaisseur du substrat) est sensiblement égale ou légèrement inférieure à la longueur des nanostructures. Au contraire, comme illustré sur la figure 1b, ceux 120 des nanonets dont l'épaisseur est très inférieure à la longueur des nanostructures, c'est-à-dire des nanofils dans cet exemple, sont qualifiés de bidimensionnel ou « 2D ».

L'intérêt suscité par l'emploi de nanonets, et en particulier des nanonets de type 2D, pour réaliser toutes sortes de dispositifs comme ceux mentionnés ci-dessus, provient des propriétés très intéressantes que l'assemblage de telles nanostructures permet d'obtenir.

Ces propriétés sont très diverses et incluent la possibilité d'obtenir : une surface spécifique et une porosité élevées ; une bonne conductivité électrique avec une bonne transparence optique. De plus, les nanonets peuvent être à la fois mécaniquement résistants et flexibles : un nanonet composé de nanostructures 1D bien entrelacées est très flexible comparé aux films minces. Il a été montré qu'une telle structure en réseau est capable de s'adapter sans cassure à la morphologie d'un substrat et peut servir à former un système mécanique dit suspendu. En outre, les nanonets étant composés de millions de nanostructures 1D, on obtient de fait à l'échelle macroscopique une bonne reproductibilité et une tolérance aux défauts importante. En effet, les propriétés des nanonets que l'on peut observer résultent d'une combinaison statistique des propriétés d'un très grand nombre de nanostructures individuelles, c'est-à-dire une moyenne de celles-ci, qui est donc bien plus reproductible que celles de nanostructures individuelles et une nanostructure défectueuse n'entraine pas de défaut majeur. On obtient ainsi potentiellement des composants de haute qualité car il est relativement facile de synthétiser des nanostructures 1D sans défaut sur de grandes zones permettant ainsi d'améliorer notamment les propriétés électriques et optiques des nanonets. De plus, pour les nanofils de petits diamètres, des effets quantiques sont susceptibles d'apparaître dont le nanonet correspondant peut alors avantageusement tirer parti. Enfin, une fonctionnalisation des nanonets est possible en attachant des espèces chimiques ou des matériaux nanométriques, tels que des nanoparticules, aux nanostructures d'un nanonet. On ajoute alors d'autres propriétés au nanonet grâce à la synergie entre les nanoparticules et les nanostructures 1D.

L'assemblage de nanostructures 1D pour former un nanonet est une étape critique qui conditionne les propriétés finales des réseaux obtenus. Des techniques de fabrication fiables, simples et à bas coûts ont ainsi été développées. Il existe différentes méthodes pour préparer des nanonets comme par exemple la croissance directe de réseaux réalisée généralement par « déposition chimique en phase vapeur » ou CVD, acronyme de l'anglais « chemical vapor déposition ». Depuis plusieurs années, l'auto-assemblage de nanostructures à partir d'une solution de ces dernières est cependant souvent préféré. En effet, si la croissance directe mène le plus souvent à des nanonets 3D dont l'intégration à grande échelle est limitée par des étapes technologiques complexes et coûteuses, les méthodes par auto-assemblage de nanostructures présentes dans une solution peuvent être réalisées à température ambiante et à faibles coûts.

Ainsi, des nanonets 2D tels qu'illustrés par la figure 1b composés de nanofils 101 ou nanotubes aléatoirement orientés sur un substrat peuvent être obtenus de manière rapide et peu couteuse à l'aide de nombreuses techniques, partant de solutions liquides, telles que le dépôt par projection ou « spray coating », le dépôt de gouttes ou « drop casting », le dépôt par enduction centrifuge ou « spin coating », l'auto-assemblage de nanostructures sur un substrat modifié chimiquement, la technique dite de Langmuir-Blodgett par immersion d'un film solide dans un liquide ou le dépôt par filtration sous vide.

Cependant, s'il existe bien une littérature très riche issue de travaux de recherche et de développement décrivant les caractéristiques et les moyens d'obtenir des nanonets 2D à partir, par exemple, de nanotubes de carbone et de nanofils d'argent ou de cuivre, essentiellement dans le but de réaliser des matériaux transparents conducteurs, l'obtention de nanonets semi-conducteurs est peu ou pas décrite. L'utilisation de nanonets semi-conducteurs paraît en effet fort limitée pour des applications électriques du fait de la faible conductivité des nanonets issus de semi-conducteurs. Le silicium et le germanium s'oxydent très rapidement à l'air libre. Une couche d'oxyde apparaît alors aux jonctions nanofil-nanofil qui empêche après fabrication tout passage de courant entre eux.

La publication WO2014070611 A1 présente une méthode d'assemblage de nanofils mettant en œuvre un chauffage important et éventuellement une désoxydation de la structure assemblée. Ce document ne résout pas le problème de la forte discontinuité électrique entre nanofils, ou au prix d'un cout thermique très élevé.

US2014/042390 A1 montre la formation de réseaux de nanostructures carbonées pour des applications de stockage d'énergie.

WO2007/100551 A2 présente une intégration de transistors à effet de champs sur des nanofils de silicium.

US2013/146335 A1 présente la formation d'une électrode transparente à base de siliciures métalliques.

C'est donc un objet de l'invention que de décrire un procédé qui élargit les applications des nanonets faits à partir de semi-conducteurs, en améliorant leur conductivité électrique. En particulier, c'est un objet de l'invention de décrire une méthode permettant l'élaboration de nanonets de silicium ou de germanium stables à long terme sous atmosphère oxydante et laissant passer un courant électrique significatif au travers de ceux-ci sur des distances inter électrodes largement supérieures à la longueur des nanofils qui les composent c'est-à-dire en autorisant effectivement l'utilisation de ces nanofils en réseau et non pas en les exploitant pour leurs seules propriétés individuelles.

D'autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Un aspect de l'invention est un procédé de réalisation d'un réseau de nanostructures selon la revendication 1.

Alors que l'état de la technique a développé un préjugé consistant à penser que les nanostructures à partir de semi-conducteurs ne peuvent avoir d'applications électriques performantes, l'invention combat ce préjugé avec une étape de désoxydation suivie d'un renforcement des liaisons entre les nanostructures, cette étape évitant une ré-oxydation ultérieure des zones de contact entre les nanostructures.

Selon un aspect de l'invention, le fait de réaliser la désoxydation avant de renforcer la liaison permet de préparer cette liaison au mieux du point de vue de la continuité électrique des jonctions, sans nécessiter une fusion même locale du matériau au niveau des jonctions entre nanostructures.

Alors que WO2014070611 A1 envisage une désoxydation et un renforcement de liaison dans une seule étape, et pour des raisons d'état de surface externe (notamment pour établir un contact des surfaces externes des nanostructures avec d'autres composants d'un dispositif), l'invention combat ce préjugé et réalise la désoxydation en tant qu'étape préliminaire à celle du renforcement de liaisons, et pour des raisons de continuité électrique entre nanostructures, ce qui est donc différent tant en fonction qu'en résultat.

Suivant un aspect de l'invention, le renforcement de la liaison comprend un traitement thermique sous forme de recuit. Cela permet de renforcer la liaison sans un trop important apport de chaleur. Ce traitement ou recuit est en outre opéré à température relativement faible de 400°C, inférieure à une température de fusion voire de fluage du matériau d'une nanostructure au niveau de la jonction.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

- Les figures 1a et 1b montrent des nanonets de structures différentes.
- Les figures 2a à 2d illustrent des étapes d'un procédé exemplaire de formation d'un nanonet composé de nanofils issus d'un matériau semi-conducteur, ce procédé n'étant pas compris dans l'invention revendiquée.
- Les figures 3a et 3b montrent des résultats de conductance électrique de nanonets réalisés en incluant l'étape de désoxydation du procédé de l'invention.
- Les figures 4a et 4b montrent des résultats de conductance électrique de nanonets réalisés en incluant aussi l'étape de recuit thermique d'un aspect du procédé de l'invention.
- Les figures 5a à 5d montrent des microphotographies de jonctions entre nanofils de nanonets sur lesquels on a effectué l'étape de désoxydation.
- Les figures 6a à 6d montrent des microphotographies de jonctions entre nanofils de nanonets sur lesquels on a effectué les étapes de désoxydation et de recuit thermique.
- La figure 7 résume deux étapes possibles d'un procédé de réalisation d'un réseau de nanostructures exemplaire.

Les dessins joints sont donnés à titre d'exemples et ne sont pas limitatifs de l'invention.

## DESCRIPTION DÉTAILLÉE DE L'INVENTION

Avant d'entrer dans le détail de modes de réalisation de l'invention, notamment en référence aux figures, on introduit ci-après brièvement des caractéristiques purement optionnelles que l'invention peut présenter seules ou selon toutes combinaisons entre elles :

- le traitement thermique a une durée idéale d'une minute ;
- le traitement thermique est opéré moins de 72 heures après l'étape de désoxydation, et avantageusement moins d'une heure, de préférence moins d'un quart d'heure ;
- l'étape de renforcement de la liaison est configurée pour produire un frittage ou un collage direct au niveau de zones de contact ;
- l'exposition au flux de vapeurs d'acide est opérée pendant au moins 30s, les vapeurs d'acide ayant de préférence une concentration comprise entre 40% et 60%;
- on utilise de l'acide fluorhydrique ou une solution d'acide fluorhydrique et de fluorure d'ammonium pour l'étape d'exposition ;
- les nanostructures formées sont des nanofils ;
- particulièrement dans le cas de nanofils de $10\mu m$ de long (ou de longueur comprise entre 8 et 12 $\mu m$), on sélectionne une densité de nanofils du réseau supérieure à $8*10^6$, avantageusement au moins de $13*10^6$ nanofils par $cm^2$ et de préférence égale à $27*10^6$ nanofils par $cm^2$. Dans le cas de nanofils de longueur différente, on pourra éventuellement se reporter à la théorie de la percolation, décrite plus loin, pour déterminer la densité minimum autorisant la conduction.

Selon l'invention, le procédé comprend une étape de formation d'au moins une couche de contact électrique sur les nanostructures après l'étape de désoxydation et après l'étape de renforcement de la liaison ;

- on utilise un substrat comprenant une couche isolante superficielle ;
- l'étape de formation des nanostructures est faite à partir de silicium et/ou de germanium et/ou d'un alliage de silicium et de germanium ;
- on forme des nanostructures dopées p formant un premier sous réseau, et des nanostructures dopées n formant un deuxième sous réseau, les premier et deuxième sous réseaux ayant des zones de contact. Le premier sous réseau peut être formé avant ou après le deuxième sous réseau.
- on effectue un collage des premier et deuxième sous réseaux par un traitement thermique.
- le renforcement de la liaison comprend un traitement thermique opéré à température relativement faible de 400°C, à savoir en particulier inférieure à une température de fusion voire de fluage du matériau d'une nanostructure au niveau de la jonction.

L'emploi de basses températures permet de ne pas modifier les propriétés, notamment optiques et/ou électriques, du réseau. D'une manière générale, l'invention comporte après formation des nanostructures, des étapes permettant d'établir une continuité électrique satisfaisante entre les nanostructures, pour des applications électriques. Pour y parvenir, l'invention réalise une désoxydation des nanostructures qui est suivie d'une étape de renforcement des liaisons inter-nanostructures. Cette combinaison d'étapes assure la mise en continuité électrique souhaitée alors qu'une désoxydation seule aurait été considérée comme inutile du fait de la ré-oxydation qui s'ensuivrait. L'obtention des nanostructures est possible par toute technologie courante et l'invention est utilisable pour toute configuration de nanostructures et pas seulement pour des nanonets. Les réseaux illustrés aux figures 1a et 1b peuvent être obtenus. Le terme « nanostructure » s'entend notamment de structures d'échelle dimensionnelle nanométrique, par exemple entre 1 et 1 000 nanomètres dans l'une au moins de ses directions.

L'invention comporte, après la désoxydation, une étape de renforcement de la liaison au niveau des zones de contact entre les nanostructures du réseau. Cette étape comprend un traitement thermique sous forme de recuit opéré à une température de 400°C pendant au moins 10 secondes sous atmosphère neutre. Le renforcement produit une liaison plus résistante, particulièrement avec une adhésion moléculaire, en faisant agir des forces de Van der Waals, via un frittage ou un collage direct, par exemple hydrophobe.

L'étape de renforcement n'est pas forcément réalisée immédiatement après l'étape de désoxydation.

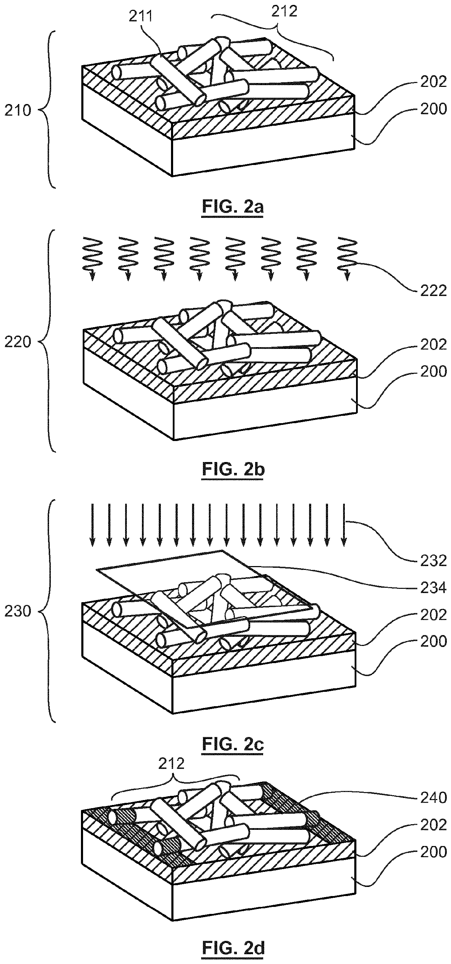

Les **figures 2a à 2d** illustrent des étapes d'un procédé exemplaire de formation d'un nanonet, ce procédé n'étant pas compris dans l'invention revendiquée. Elles correspondent à un exemple pour des dispositifs à base de nanonets dont la densité est dans cet exemple de $27 \times 10^6$ nanofils par $cm^2$ et où les nanofils sont en silicium. Ce procédé comprend les étapes décrites ci-après. En revanche, dans le procédé selon l'invention, la formation des contacts électriques est effectuée après l'étape de désoxydation et après une étape de renforcement de la liaison, qui n'est pas décrite dans l'exemple de la figure 2.

Tout d'abord, à l'étape 210, les réseaux 212 de nanofils, par exemple 211, sont transférés sur un substrat de silicium 200 recouvert d'une couche mince 202 de nitrure de silicium (Si3N4) d'une épaisseur de 208 nm dans cet exemple.

Ensuite, à l'étape suivante 220, les nanonets sont exposés pendant 30 secondes à des vapeurs 222 d'acide fluorhydrique (HF) ou d'une solution d'acide fluorhydrique et de fluorure d'ammonium. On peut utiliser une solution d'acide fluorhydrique (HF) diluée entre 30% et 70% et avantageusement entre 45% et 55% pour la génération de ces vapeurs ; la dilution est de 49% dans cet exemple. Ce traitement permet d'éliminer l'oxyde natif d'une épaisseur de quelques nanomètres, oxyde qui se forme spontanément en présence d'air et qui recouvre toute la surface des nanofils de silicium. Cela permet d'obtenir un contact direct entre les nanofils de silicium et va aussi avantageusement permettre d'assurer un bon contact électrique avec les électrodes métalliques.

Selon l'invention, le procédé continue avec une étape de renforcement de la liaison entre les nanofils au niveau des contacts telle que revendiquée. Par contre, dans l'exemple de la figure 2, immédiatement après, à l'étape 230, au moyen d'un évaporateur à faisceau d'électrons, les contacts métalliques sont déposés 232 sur les nanonets au travers un masque d'évaporation 234. Le dépôt des contacts comprend le dépôt d'une couche par exemple de 120 nm de nickel (Ni), d'une couche par exemple de 180 nm d'aluminium (Al) et d'une couche par exemple de 50 nm d'or (Au).

Le résultat est comme montré sur la figure 2d où les contacts 240 sont situés de part et d'autre du nanonet 212 et assurent un bon contact électrique avec ce dernier. Le dispositif de la figure 2d est dans ce cas une simple structure de test.

Selon l'invention, les contacts métalliques sont réalisés après l'étape de renforcement décrite plus loin.

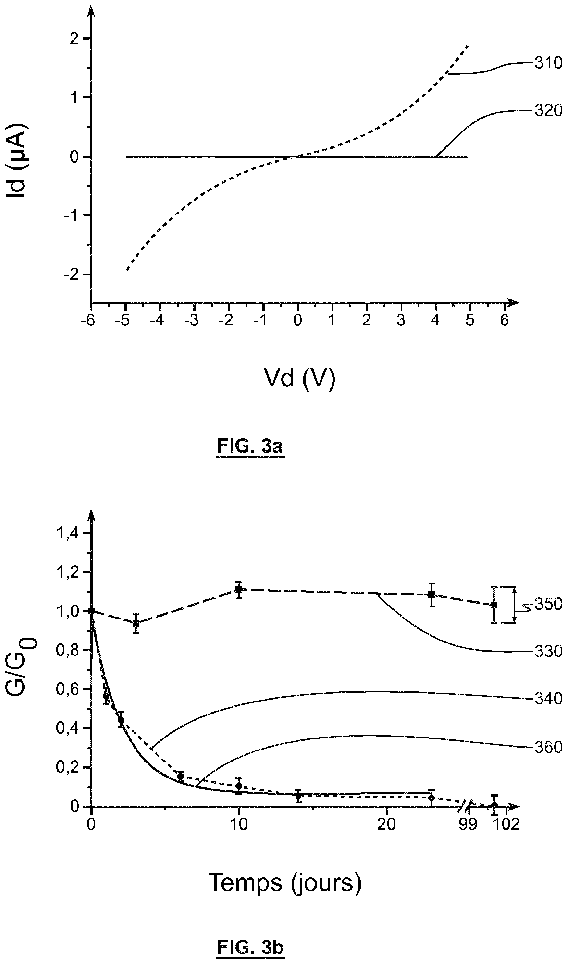

Les figures 3a et 3b illustrent, respectivement, d'une part, une caractéristique courant-tension typique que l'on obtient avec le type de dispositifs réalisés avec le procédé décrit dans la figure précédente et, d'autre part, l'évolution dans le temps des propriétés électriques de conductivité en fonction de l'atmosphère dans laquelle le dispositif est maintenu.

La figure 3a montre que la conduction du nanonet est bien bidirectionnelle et est sensiblement identique quelle que soit la polarité appliquée. La courbe courant-tension 310 est celle typique d'un réseau de nanofils de silicium, par exemple obtenus par une croissance vapeur liquide solide, de type n dégénérés, par exemple avec un dopage de $10^{19}$ atomes par cm$^3$, ayant une distance inter électrodes de 50 $\mu$m ($\mu$m ou micron c'est-à-dire : $10^{-6}$ mètre).

L'emploi de semi-conducteurs dopés n'est aucunement limitatif de l'invention et cette dernière a même l'avantage de produire des réseaux de nanostructures exploitant des propriétés de semi-conductivité, à partir de semi-conducteurs non dopés. Comme déjà mentionné dans la figure 1, la densité de nanofils est dans l'exemple de $27 \times 10^6$ nanofils par cm$^2$. Une même courbe courant-tension sans nanonet de silicium est également tracée sur ce graphe comme référence 320.

A titre indicatif pour la densité des nanofils de l'invention, on peut sélectionner une densité de nanofils supérieure à la limite du seuil de percolation.

Le seuil de percolation, dc, est définissable grâce à la théorie de la percolation en fonction de la longueur des nanostructures, $L_{NF}$, par :

$$d_c = \frac{4.326^2}{\pi L_{NF}^2}$$

(Formule issue de Hu et al. 2004 Nano Letters. 4 No.12 2513-2517)

Il n'y a pas de densité maximum d'un point de vue conduction électrique, sachant que les lois de la percolation s'appliquent entre dc et 5 à 7dc, au-delà le réseau adopte un comportement massif qui peut tout aussi bien être intéressant.

La figure 3b montre l'évolution au cours du temps (en nombre de jours) de la conductance normalisée (G/G$_0$) à -5 V pour des nanonets stockés, d'une part, dans de l'azote 330 et, d'autre part, à l'air libre 340. La variabilité de conductance obtenue pour trois dispositifs différents à base de nanonet ayant une même densité de nanofils, c'est-à-dire: $27 \times 10^6$ nanofils par cm$^2$, est indiquée par les intervalles, par exemple, 350. La courbe 360 correspond à l'ajustement exponentiel de la décroissance de la conductance au cours du temps des nanonets de silicium stockés dans l'air.

Les figures 3a et 3b montrent que du fait du traitement aux vapeurs HF, effectué à l'étape 220 avant le dépôt des électrodes métalliques, les nanofils de silicium sont initialement passivés par des liaisons Si-H. Initialement l'épaisseur d'oxyde autour des nanofils est habituellement très mince, de l'ordre de quelques angströms (angström = $10^{-10}$ mètre) voire nulle. Lors d'un maintien sous atmosphère neutre, par exemple l'azote, les surfaces ne sont pas modifiées et le courant reste stable comme le montre la courbe 330. Au contraire, en présence d'oxygène, comme on le voit avec la courbe 340, les surfaces s'oxydent et le courant chute rapidement pour devenir finalement nul. Cependant, on observe que le traitement aux vapeurs HF 220 qui entraîne aussi une passivation des nanofils, permet de ralentir l'oxydation au niveau des jonctions nanofil-nanofil avec, comme le montre la courbe 360, une constante de temps de 3 jours contre seulement quelques heures observées pour des nanofils d'un diamètre de 85 nm.

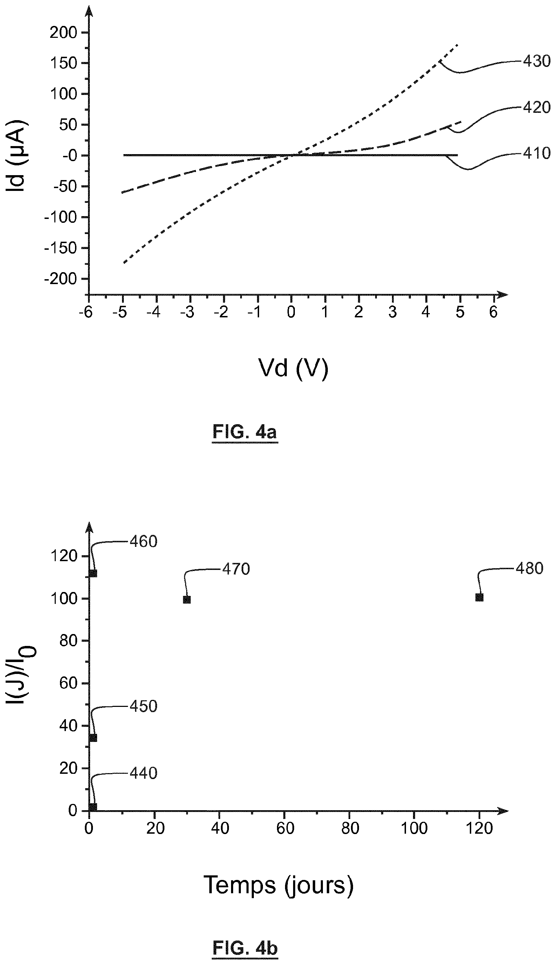

Les figures 4a et 4b illustrent ensuite les propriétés électriques obtenues avec des nanonets sur lesquels on a appliqué toutes les étapes du procédé de l'invention et pas seulement l'étape de désoxydation 220 dont les effets ont été discutés dans les figures précédentes. Ces propriétés sont étudiées à l'issue de chaque étape du procédé puis dans le temps sur une durée de plusieurs mois.

Dans un premier temps, comme déjà décrit à l'étape 220, afin d'enlever l'oxyde natif aux jonctions entre les nanofils de silicium, un traitement à l'acide fluorhydrique (HF) dilué à 49%, en phase vapeur, pendant 30 secondes est effectué sur des nanonets du type de ceux illustrés par la figure 1b. Comme on l'a vu, cela permet d'obtenir un contact direct entre les nanofils de silicium. Les caractéristiques courant-tension des nanonets étudiés montrées sur la figure 4a indiquent qu'une augmentation du courant d'un ordre de grandeur 420 peut être observée après cette opération par rapport à la courbe de référence 410 qui correspond à la conduction initiale des nanonets avant traitement HF. On notera que la caractéristique courant-tension 420 reste, comme dans la figure 3a, non linéaire.

Selon l'invention, dans un second temps, afin d'obtenir un collage des nanofils entre eux au niveau des jonctions nanofil-nanofil (NF-NF), on procède à un recuit par exemple à une température de 400°C pendant au moins 1 minute sous azote. Après cette opération de recuit on constate que le courant mesuré augmente à nouveau d'un ordre de grandeur et on constate également que la caractéristique courant-tension obtenue 430 est alors devenue sensiblement linéaire.

La durée du recuit donnée ci-dessus n'est pas limitative mais est un compromis entre durée du traitement thermique et taille d'interface stabilisée entre nanofils (au niveau d'une zone de cou). Selon l'invention la durée est supérieure à 10s. Typiquement, elle peut, selon les résultats souhaités, se situer entre 10 secondes et 3 heures voire plus.

Enfin, la stabilité dans le temps de ces dispositifs optimisés a été étudiée lors d'un stockage de ceux-ci à l'air libre jusqu'à une durée de 120 jours. Le graphe de la figure 4b résume l'évolution du courant à -5 V normalisé à la valeur observée au premier jour, c'est-à-dire $I_{(j)}/I_{(0)}$. Pour comparaison la valeur initiale du courant au premier jour 440 avant tout traitement appliqué aux nanonets et celle après désoxydation HF de ceux-ci 450 sont indiquées. Après que le recuit à 400°C a été effectué les valeurs observées au premier jour de stockage, après 30 jours et après 120 jours, c'est-à-dire, respectivement 460, 470 et 480, sont indiquées.

Le courant dans les dispositifs optimisés 460 a donc été multiplié par 100 par rapport aux dispositifs non traités 440. Seule une légère diminution du courant est observée 470 dans les premiers jours, mais ensuite le courant se stabilise 480 en dépit du fait que les nanonets sont stockés à l'air libre, c'est à dire dans un milieu oxydant.

Afin de démontrer que le collage des nanofils est effectif et accéder à la structure des jonctions NF-NF, des observations à l'aide d'un microscope électronique à transmission haute résolution (HRMET) ont été effectuées. Pour cela, des échantillons à base de nanonets de silicium, recuits et non recuits, maintenus plusieurs mois en atmosphère oxydante, ont été préparés en sections transverses pour être analysés à l'aide d'une technique dite FIB-SEM où l'on utilise un « faisceau d'ions focalisé » ou FIB de l'anglais « focused ion beam » à l'aide d'un appareillage de type « microscope électronique à balayage » plus connu sous son acronyme SEM de l'anglais « scanning electron microscope ».

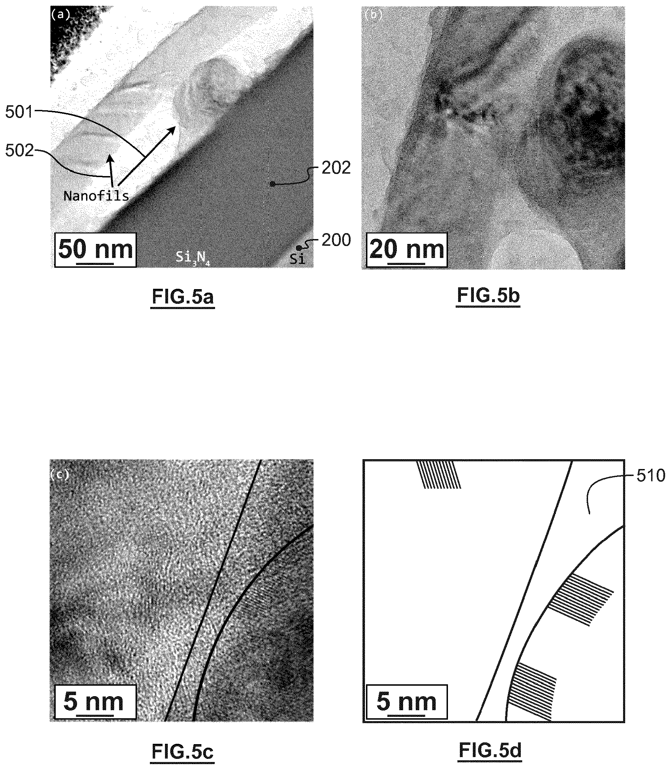

Dans un premier temps, les propriétés structurales d'une jonction NF-NF, située au sein d'un nanonet non recuit et stocké plusieurs mois à l'air libre, ont été analysées. La figure 5, composée des figures 5a à 5d, montre les images obtenues par microscopie électronique haute résolution d'une jonction NF-NF non recuite. L'image de la figure 5a présente une vue d'ensemble de la zone d'observation. On y retrouve le substrat de silicium 200 recouvert d'une couche mince 202 de nitrure de silicium, d'une épaisseur de 192 nm dans cet exemple, ainsi que les deux nanofils étudiés. Le nanofil perpendiculaire 501 à la lame mince, d'un diamètre de 67 nm, est légèrement placé de biais, ce qui explique l'observation de plusieurs projections circulaires représentant l'avant et l'arrière de ce nanofil. Le nanofil longitudinal 502, parallèle à la lame mince, d'un diamètre de 60 nm, est légèrement courbé du fait qu'il passe au-dessus de l'autre nanofil. Cette courbure induit des contraintes au sein du réseau qui se traduisent par l'apparition de contrastes foncés le long de ce nanofil. Les figures 5b et 5c montrent l'interface entre les deux nanofils. La figure 5c présente cette interface à plus fort grossissement au niveau de leur zone de contact. Enfin, la figure 5d interprète ce qui est observé sur la figure 5c, celle à fort grossissement. On y voit que les deux nanofils sont séparés par environ 2 nm de matériau amorphe 510, qui est sans aucun doute de l'oxyde de silicium formé lors de l'exposition des nanonets à l'oxygène de l'air. Ainsi, au niveau des jonctions NF-NF, au sein d'un nanonet non recuit et stocké à l'air libre, il y a présence d'un matériau isolant.

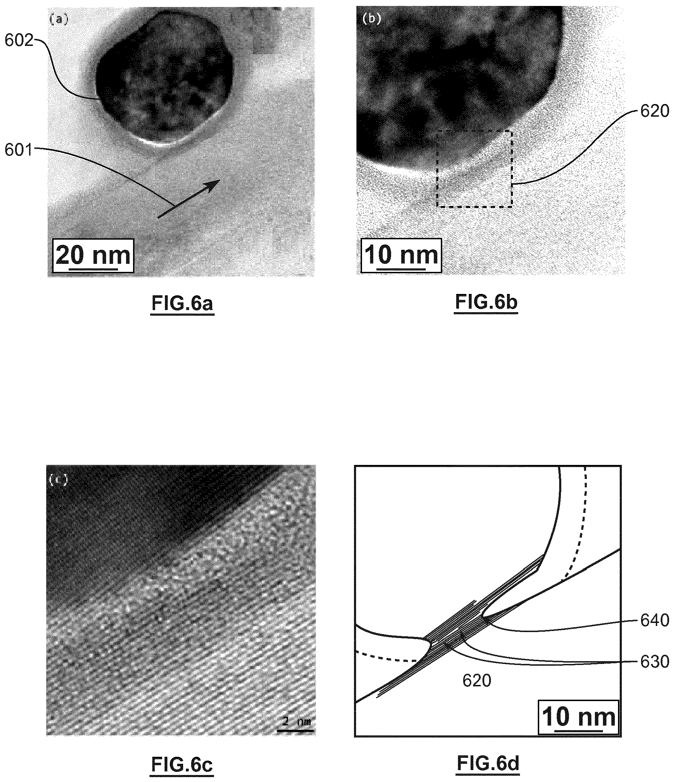

Dans un second temps, les propriétés structurales d'une jonction NF-NF au sein d'un nanonet recuit à 400°C pendant une minute après avoir été exposé, comme précédemment, à des vapeurs d'acide fluorhydrique et ensuite stocké plusieurs mois à l'air libre sont présentées. La figure 6, composée des figures 6a à 6d, montre les images obtenues par microscopie électronique haute résolution de la jonction NF-NF recuite. L'image de la figure 6a est une vue d'ensemble de la zone d'observation où l'on retrouve un nanofil longitudinal 601 dont le cœur de silicium cristallin présente un diamètre de 41 nm et la coquille de silice une épaisseur de 8 nm environ. Ce nanofil est cristallisé comme l'atteste la présence de plans cristallographiques sur l'image. Un nanofil transverse 602, légèrement aplati, présente un diamètre de cœur maximum de 54 nm et une coquille de silice d'environ 6 nm d'épaisseur. Ce nanofil est également monocristallin.

Les figures 6b et 6c montrent l'interface entre les deux nanofils, la figure 6c montrant avec un plus fort grossissement la zone de contact 620 entre les nanofils. La figure 6d interprète ce qui est observé sur la figure 6b. Sur ces deux micrographies, il est possible d'observer une continuité entre les plans cristallographiques (111) du nanofil transverse et ceux du nanofil longitudinal au niveau de la jonction avec l'apparition de deux dislocations 630. Il existe donc une continuité du réseau cristallin de silicium au niveau de la jonction. Il s'est ainsi formé sous l'effet du recuit un cou 640, c'est à dire une zone d'interface formée par le recuit, d'une largeur de 11 nm environ entre les deux nanofils. Ensuite, lors de l'exposition à l'air, les nanofils s'oxydent en surface sans affecter cependant l'interface entre les nanofils car ceux-ci ont été collés sous l'effet du recuit.

Ainsi, de toute évidence, lors du recuit à 400°C, les nanonets désoxydés par les vapeurs d'acide fluorhydrique, subissent un frittage naturel ou collage direct hydrophobe qui se traduit par l'apparition du cou 640 de l'ordre d'une dizaine de nanomètres. En raison de ce collage, l'oxydation au niveau des jonctions ne peut plus se produire puisque le nanonet est alors constitué d'un assemblage polycristallin de silicium où tous les nanofils sont collés les uns aux autres, comme le démontre la continuité des plans atomiques sur la figure 6c.

A l'opposé, comme on l'a vu dans les figures 5a à 5d, en l'absence de recuit, l'oxydation se produit aux interfaces entre nanofils, provoquant ainsi l'apparition de silice entre chaque nanofil du nanonet qui empêche le passage du courant.

Le collage direct des nanofils au niveau des jonctions explique donc bien qu'il soit possible d'augmenter le courant circulant au sein des nanonets de deux ordres de grandeur et d'obtenir des caractéristiques courant-tension sensiblement linéaires 430 comme montré sur la figure 4a.

Le principe de l'invention est d'appliquer une succession de traitements chimiques et thermiques après assemblage du nanonet de silicium sur son substrat afin de tout d'abord désoxyder les nanofils du réseau et ensuite permettre le frittage ou collage moléculaire du réseau au niveau des jonctions nanofils-nanofils. Ainsi, le réseau de nanofils se transforme en un réseau polycristallin de silicium et une oxydation ultérieure du nanonet se traduit par une oxydation en surface et non plus aux jonctions nanofils-nanofils. De la sorte, les propriétés électriques du nanonet restent stables dans le temps, y compris sous atmosphère oxydante.

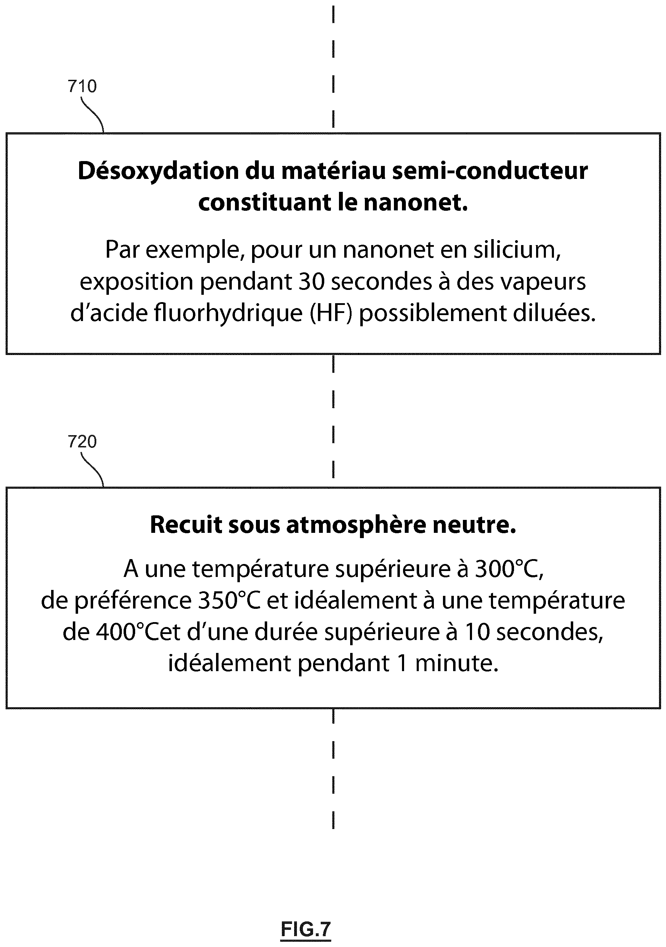

Les étapes d'un procédé exemplaire qui interviennent après la mise en forme du nanonet sont résumées sur la figure 7.

- Au cours d'une première étape 710 on procède à une désoxydation du matériau semi-conducteur constituant le nanonet, par exemple fait de silicium, en l'exposant pendant 30 secondes à des vapeurs d'acide fluorhydrique (HF) possiblement diluée ou par tout autre traitement de désoxydation en phase vapeur approprié. Un traitement en phase liquide est aussi possible. Cependant, la phase vapeur endommagera moins le réseau.
- Dans une seconde étape 720, on effectue un recuit, selon l'invention à une température de 400°C sous atmosphère neutre et d'une durée supérieure à 10 secondes, idéalement pendant 1 minute.

On notera ici que dans le procédé de l'invention le moment où l'on effectue l'opération de collage des nanofils, c'est-à-dire le recuit, est déplacé par rapport aux exemples décrits plus haut. En effet, le procédé inventif opère cette opération avant le dépôt des électrodes métalliques.

Dans les exemples précédents elle a été appliquée après le dépôt des électrodes car cela permet de réaliser en même temps la siliciuration des contacts métalliques.

L'apport de l'invention est donc de préserver dans le temps les propriétés électriques des nanonets faits de matériaux semi-conducteurs, par exemple ceux faits de nanofils en silicium, au moyen d'une opération de type collage direct hydrophobe ou frittage naturel. Cependant, la technique de préparation employée (désoxydation) et la température de travail peu élevée égale à 400°C, place l'invention dans un budget thermique faible.

Les applications potentielles du procédé de l'invention sont nombreuses, par exemple :

- pour la réalisation de cellules solaires semi-transparentes en combinant des nanonets dopés n et des nanonets dopés p qui sont ensuite collés ensemble par traitement thermique. Les avantages liés à l'utilisation de nanonets semi-conducteurs font qu'on obtient alors une meilleure collection de la lumière du fait de la géométrie, une multiplication des jonctions PN à chaque point de contact et une distance à parcourir par les porteurs qui est réduite. Si les nanofils employés présentent un diamètre suffisamment petit, inférieur à 10 nm, pouvant faire apparaitre des effets de confinement quantique, une bande interdite directe est créée qui permettra une meilleure absorption. La flexibilité mécanique des nanonets permet aussi d'imaginer de nouvelles géométries.
- pour la détection d'espèces biologiques ou chimiques. Par fonctionnalisation de surface, il est en effet possible de rendre le nanonet sensible à une grande variété d'espèces qui vont modifier les propriétés de surface du nanonet et donc ses propriétés électriques. Plus les nanofils auront un diamètre petit, plus l'effet sera important car la surface devient prépondérante par rapport au volume. Ensuite, la géométrie du nanonet apporte une surface spécifique plus élevée qui permet d'augmenter sa sensibilité. Transparence et flexibilité peuvent également être un avantage pour ce type d'applications.
- pour la réalisation de systèmes électroniques flexibles. Le procédé de l'invention permet la réalisation de matériaux semi-conducteurs flexibles et semi transparents qui peuvent entrer dans la composition de transistors flexibles, non sensibles aux ultra-violets (UV) et qui ne se détériorent pas en présence d'oxygène, ce qui est le point faible des matériaux organiques généralement utilisés pour ce type d'application.
- pour la réalisation de photo-détecteurs. La conductivité d'un nanonet de silicium est en effet modifiée en fonction de son éclairement, ce qui permet la réalisation de photo-détecteurs à vitesse de réponse élevée en raison de leur géométrie.

## Revendications

1. Procédé de réalisation d'un réseau (212) de nanostructures à partir d'au moins un matériau semi-conducteur, comprenant une étape de formation des nanostructures à la surface d'un substrat (200), au moins une partie des nanostructures ayant des zones de contact entre-elles, le procédé comprenant après l'étape de formation, une étape de désoxydation et une étape de renforcement de la liaison entre nanostructures au niveau des zones de contact, l'étape de renforcement de la liaison comprenant un traitement thermique sous forme de recuit, le procédé comprenant une étape (230) de formation d'au moins une couche de contacts électriques (240), configurée pour former des électrodes sur les nanostructures, après la désoxydation (220) et après l'étape de renforcement de la liaison, **le procédé caractérisé en ce que** la désoxydation consiste en, après l'étape de formation des nanostructures et avant l'étape de renforcement de la liaison, une étape de désoxydation (220) de la surface des nanostructures qui comprend l'exposition des nanostructures à un flux de vapeurs d'une solution d'acide, et **en ce que** le traitement thermique est opéré à une température de 400°C, a une durée supérieure à 10s, et est sous atmosphère neutre.

2. Procédé selon la revendication précédente, dans lequel le traitement thermique a une durée égale à une minute.

3. Procédé selon l'une des revendications précédentes, dans lequel le traitement thermique est opéré moins de 72 heures après l'étape de désoxydation (220).

4. Procédé selon l'une des revendications précédentes, dans lequel l'étape de renforcement de la liaison est configurée pour produire un frittage ou un collage direct au niveau de zones de contact.

5. Procédé selon l'une des revendications précédentes, dans lequel l'exposition au flux de vapeurs d'acide est opérée pendant au moins 30s.

6. Procédé selon l'une des revendications précédentes, dans lequel on utilise de l'acide fluorhydrique ou une solution d'acide fluorhydrique et de fluorure d'ammonium pour l'étape d'exposition.

7. Procédé selon l'une des revendications précédentes dans lequel les nanostructures formées sont des nanofils.

8. Procédé selon la revendication précédente, dans lequel on sélectionne une densité de nanofils du réseau supérieure à $13*10^6$ nanofils par $cm^2$ et de préférence éaale à $27*10^6$ nanofils par $cm^2$, de préférence pour des nanofils de $10\mu m$ de long.

8. Procédé selon l'une des revendications précédentes, dans lequel on utilise un substrat (200) comprenant une couche isolante superficielle (202).

9. Procédé selon l'une des revendications précédentes dans lequel l'étape de formation des nanostructures est faite à partir de silicium et/ou de germanium et/ou d'un alliage de silicium et de germanium.

10. Procédé selon l'une des revendications précédentes, comprenant la formation de nanostructures dopées p formant un premier sous réseau, et de nanostructures dopées n formant un deuxième sous réseau, les premier et deuxième sous réseaux ayant des zones de contact.

11. Procédé selon la revendication précédente, dans lequel on effectue un collage des premier et deuxième sous réseaux par un traitement thermique.

## Patentansprüche

1. Verfahren zur Herstellung eines Netzes (212) aus Nanostrukturen aus mindestens einem Halbleitermaterial, umfassend einen Schritt zur Bildung von Nanostrukturen an der Oberfläche eines Substrats (200), wobei mindestens ein Teil der Nanostrukturen Kontaktzonen miteinander aufweist, wobei das Verfahren nach dem Bildungsschritt einen Desoxdationsschritt und einen Verstärkungsschritt der Verbindung zwischen Nanostrukturen im Bereich der Kontaktzonen umfasst, wobei der Verstärkungsschritt der Verbindung eine Wärmebehandlung in Form von Tempern umfasst, wobei das Verfahren einen Bildungsschritt (230) mindestens einer Schicht von elektrischen Kontakten (240) umfasst, der konfiguriert ist, um Elektroden auf den Nanostrukturen nach der Desoxidation (220) und nach dem Verstärkungsschritt der Verbindung umfasst, wobei das Verfahren **dadurch gekennzeichnet ist, dass** die Desoxidation nach dem Bildungsschritt der Nanostrukturen und vor dem Schritt der Verstärkung der Verbindung aus einem Desoxidationsschritt (220) der Oberfläche der Nanostrukturen besteht, der das Aussetzen der Nanostrukturen einem Fluss von Dämpfen einer Säurelösung umfasst, und dadurch, dass die Wärmebehandlung bei einer Temperatur von 400°C, über eine Dauer von mehr als 10s hinweg und unter neutraler Atmosphäre vorgenommen wird.

2. Verfahren nach dem vorstehenden Anspruch, wobei die Wärmebehandlung eine Dauer gleich einer Minute aufweist.

**3.** Verfahren nach einem der vorstehenden Ansprüche, wobei die Wärmebehandlung weniger als 72 Stunden nach dem Desoxidationsschritt (220) vorgenommen wird.

**4.** Verfahren nach einem der vorstehenden Ansprüche, wobei der Schritt zur Verstärkung der Verbindung konfiguriert ist, um eine direkte Sinterung oder Verklebung im Bereich von Kontaktzonen zu erzeugen.

**5.** Verfahren nach einem der vorstehenden Ansprüche, wobei das Aussetzen dem Fluss von Dämpfen einer Säure mindestens 30s lang vorgenommen wird.

**6.** Verfahren nach einem der vorstehenden Ansprüche, wobei eine Flusssäure oder eine Flusssäurelösung und Ammoniumfluorid für den Schritt des Aussetzens verwendet werden.

**7.** Verfahren nach einem der vorstehenden Ansprüche, wobei die gebildeten Nanostrukturen Nanodrähte sind.

**8.** Verfahren nach dem vorstehenden Anspruch, wobei eine Dichte an Nanodrähten des Netzes von mehr als $13*10^6$ Nanodrähten je $cm^2$, und vorzugsweise gleich $27*10^6$ Nanodrähten je $cm^2$, vorzugsweise für 10 $\mu$m lange Nanodrähte ausgewählt wird.

**8.** Verfahren nach einem der vorstehenden Ansprüche, wobei ein Substrat (200) verwendet wird, das eine oberflächliche Isolierschicht (202) umfasst.

**9.** Verfahren nach einem der vorstehenden Ansprüche, wobei der Schritt des Bildens der Nanostrukturen ausgehend von Silicium und/ oder Germanium und/ oder einer Legierung aus Silicium und aus Germanium erfolgt.

**10.** Verfahren nach einem der vorstehenden Ansprüche, das die Bildung von dotierten Nanostrukturen p, die ein erstes Teilnetz bilden, und von dotierten Nanostrukturen n, die ein zweites Teilnetz bilden, umfasst, wobei das erste und zweite Teilnetz Kontaktzonen aufweisen.

**11.** Verfahren nach dem vorstehenden Anspruch, wobei eine Verklebung des ersten und zweiten Teilnetzes durch eine Wärmebehandlung ausgeführt wird.

**Claims**

**1.** Method for producing a network (212) of nanostructures from at least one semiconductor material, comprising a step of forming nanostructures on the surface of a substrate (200), at least a part of the nanostructures having contact areas with one another, the method comprising, after the formation step, a deoxidation step and a step of strengthening the bond between nanostructures at the contact areas, the bond-strengthening step comprising a heat treatment in the form of annealing, the method comprising a step (230) of forming at least one layer of electrical contacts (240), configured to form electrodes on the nanostructures, after the deoxidation (220) and after the bond-strengthening step, **the method being characterised in that** the deoxidation consists, after the step of forming the nanostructures and before the step of strengthening the bond, of a step (220) of deoxidising the surface of the nanostructures which comprises exposing the nanostructures to a flow of vapours of an acid solution, and **in that** the heat treatment is carried out at a temperature of 400°C, has a duration of more than 10s, and is carried out in a neutral atmosphere.

**2.** Method according to the preceding claim, wherein the heat treatment has a duration of one minute.

**3.** Method according to one of the preceding claims, wherein the heat treatment is carried out less than 72 hours after the deoxidation step (220).

**4.** Method according to one of the preceding claims, wherein the bond-strengthening step is configured to result in direct bonding or sintering at contact areas.

**5.** Method according to one of the preceding claims, wherein the exposure to the acid vapour flow lasts at least 30s.

**6.** Method according to one of the preceding claims, wherein hydrofluoric acid or a solution of hydrofluoric acid and ammonium fluoride is used for the exposure step.

**7.** Method according to one of the preceding claims, wherein the nanostructures formed are nanowires.

**8.** Method according to the preceding claim, wherein a density of nanowires in the network of greater than $13*10^6$ nanowires per $cm^2$ is selected, preferably equal to $27*10^6$ nanowires per $cm^2$, preferably for nanowires measuring 10 $\mu$m long.

**8.** Method according to one of the preceding claims, wherein a substrate (200) comprising a surface insulating layer (202) is used.

**9.** Method according to one of the preceding claims, wherein the step of forming the nanostructures is carried out using silicon and/or germanium and/or a silicon and germanium alloy.

**10.** Method according to one of the preceding claims, comprising the formation of p-doped nanostructures forming a first subnetwork, and of n-doped nanostructures forming a second subnetwork, the first and second subnetworks having contact areas.

**11.** Method according to the preceding claim, wherein the first and second subnetworks are bonded by a heat treatment.

**FIG. 1a**

**FIG. 1b**

FIG. 2a

FIG. 2b

FIG. 2c

FIG. 2d

FIG. 3a

FIG. 3b

FIG. 4a

FIG. 4b

FIG.5a

FIG.5b

FIG.5c

FIG.5d

602

601

20 nm

FIG.6a

620

10 nm

FIG.6b

2 nm

FIG.6c

640

630

620

10 nm

FIG.6d

710

## Désoxydation du matériau semi-conducteur constituant le nanonet.

Par exemple, pour un nanonet en silicium, exposition pendant 30 secondes à des vapeurs d'acide fluorhydrique (HF) possiblement diluées.

720

## Recuit sous atmosphère neutre.

A une température supérieure à 300°C, de préférence 350°C et idéalement à une température de 400°Cet d'une durée supérieure à 10 secondes, idéalement pendant 1 minute.

FIG.7

**EP 3 023 386 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2014070611 A1
- US 2014042390 A1
- WO 2007100551 A2
- US 2013146335 A1

### Littérature non-brevet citée dans la description

- **HU et al.** *Nano Letters,* 2004, vol. 4 (12), 2513-2517